# EUROPÄISCHE PATENTSCHRIFT

(11) **EP 2 507 913 B1**
(45) Veröffentlichungstag und Bekanntmachung des Hinweises auf die Patenterteilung: **09.01.2019**
(21) Anmeldenummer: 10776694.1
(22) Anmeldetag: 12.11.2010
(51) Int. Cl.: H03K 17/96, H03K 17/975

(54) **HAUSHALTSGERÄT MIT EINER BEDIENEINRICHTUNG UND VERFAHREN ZUM BEDIENEN EINES HAUSHALTSGERÄTS**
HOUSEHOLD APPLIANCE HAVING A CONTROL APPARATUS AND METHOD FOR OPERATING A HOUSEHOLD APPLIANCE
APPAREIL MÉNAGER DOTÉ D'UN DISPOSITIF DE COMMANDE ET PROCÉDÉ DE COMMANDE D'UN APPAREIL MÉNAGER

(30) Priorität: 04.12.2009 DE 102009047510
(43) Veröffentlichungstag der Anmeldung: 10.10.2012
(73) Patentinhaber: BSH Hausgeräte GmbH, 81739 München (DE)
(72) Erfinder: LAASER, Walter, 93164 Laaber (DE)
(86) Internationale Anmeldenummer: PCT/EP2010/067339
(87) Internationale Veröffentlichungsnummer: WO 2011/067089

(56) Entgegenhaltungen:
- EP-A1- 1 876 515
- DE-A1-102005 041 113
- DE-A1-102005 053 928
- FR-A1- 2 455 818
- US-A1- 2009 146 533

## Beschreibung

Die Erfindung betrifft ein Haushaltsgerät mit einer Bedieneinrichtung zum Bedienen des Haushaltsgeräts. Die Bedieneinrichtung umfasst ein piezoelektrisches Element, wie auch ein Paar von an dem piezoelektrischen Element angeordneten Kontaktelementen. Die Bedieneinrichtung umfasst außerdem eine mit den Kontaktelementen elektrisch gekoppelte elektronische Auswerteschaltung zum Erzeugen zumindest eines Steuersignals. Die Erfindung betrifft auch ein Verfahren zum Bedienen eines Haushaltsgeräts mit Hilfe eines piezoelektrischen Elements.

Bedieneinrichtungen mit piezoelektrischen Elementen sind Stand der Technik. Die Druckschrift WO 2005/059935 A2 beschreibt eine solche Bedieneinrichtung für ein Haushaltsgerät. Ein piezoelektrisches Element befindet sich zwischen einer Abdeckung und einer Grundplatte. Durch Ausüben eines Drucks auf die Abdeckung ändert sich die Form des piezoelektrischen Elementes, und es wird eine elektrische Spannung zwischen zwei an dem piezoelektrischen Element angebrachten Kontaktelementen erzeugt. Die Amplitude der Spannung wird ausgewertet, nämlich mit Hilfe einer Auswerteschaltung.

Ein piezoelektrisches Bedienelement ist ebenfalls aus der Druckschrift DE 10 2004 052 501 A1 bekannt.

Es ergibt sich bei der Auswertung der Amplitude der induzierten Spannung bei einem piezoelektrischen Element die folgende Problematik: Werden die elektrischen Potentiale an dem piezoelektrischen Element - nämlich mit Hilfe der Kontaktelemente - durch die Auswerteschaltung abgegriffen, so baut sich die elektrische Spannung zwischen den Kontaktelementen sehr rasch wieder ab. Es müssen somit im Stand der Technik Auswerteschaltungen eingesetzt werden, die einen hochohmigen Eingangswiderstand aufweisen. Dieser ist in der Regel größer als 50 MΩ. Selbst bei Einsatz einer Auswerteschaltung mit einem solchen hohen Eingangswiderstand größer als 50 MΩ fließen die Ladungen rasch ab, und ein über eine längere Zeit andauernder Druck auf das piezoelektrische Element kann nicht detektiert werden.

Auch der Einsatz eines hochohmigen Eingangswiderstands in der Auswerteschaltungen ist bei Haushaltsgeräten hinsichtlich der EMV-Eigenschaften (elektromagnetische Verträglichkeit) problematisch. Die Auswerteschaltungen, welche die Ladungsverschiebung bzw. die induzierte Spannung des piezoelektrischen Elementes auswerten, müssen daher aufgrund der Gefahr einer Einstrahlung von elektrischen Störfeldern in unmittelbarer Nähe des piezoelektrischen Elementes - quasi direkt am piezoelektrischen Element - angeordnet sein.

Aus dem Dokument US 2009/0146533 A1 ist ein System bekannt, welches zur Messung des absoluten Drucks ausgebildet ist, der auf ein piezoelektrisches Element aufgebracht wird. Es wird eine Übergangszeit eines elektrischen Spannungsimpulses gemessen, und diese Übergangszeit stellt ein Maß für eine Kapazität des piezoelektrischen Elements dar, welche wiederum abhängig von dem aufgebrachten Druck ist.

Eine kapazitive Bedieneinrichtung mit einem piezoelektrischen Element ist des Weiteren aus der FR 2 455 818 A1 bekannt.

Die DE 2005 053 928 A1 beschreibt ein Bedienelement für ein Haushaltsgerät. Das Bedienelement umfasst eine ortsfeste Elektrode, welche eine erste Kondensatorplatte bildet, sowie eine biegbare Elektrode, die eine zweite Kondensatorplatte bildet und durch die Bedienperson gedrückt werden kann. Beim Betätigen der biegbaren Elektrode verändert sich der Abstand zwischen den Kondensatorplatten, was mittels einer elektronischen Auswerteeinrichtung detektiert wird.

Es ist Aufgabe der Erfindung, eine Lösung aufzuzeigen, wie die Bedienung eines Haushaltsgeräts mit Hilfe eines piezoelektrischen Elementes im Vergleich zum Stand der Technik verbessert werden kann.

Diese Aufgabe wird erfindungsgemäß durch ein Haushaltsgerät mit den Merkmalen gemäß Patentanspruch 1, wie auch durch ein Verfahren mit den Merkmalen gemäß Patentanspruch 8 gelöst. Vorteilhafte Ausführungen der Erfindung sind Gegenstand der abhängigen Patentansprüche und der Beschreibung.

Unter einem Haushaltsgerät wird insbesondere ein Gerät verstanden, das zur Haushaltsführung eingesetzt wird. Das kann ein Haushaltsgroßgerät sein, wie beispielsweise eine Waschmaschine, ein Wäschetrockner, eine Geschirrspülmaschine, ein Gargerät, eine Dunstabzugshaube, ein Kältegerät oder ein Klimagerät. Das kann aber auch ein Haushaltskleingerät sein, wie beispielsweise ein Warmwasserbereiter, ein Kaffeevollautomat, eine Küchenmaschine oder ein Staubsauger.

Ein erfindungsgemäßes Haushaltsgerät umfasst eine Bedieneinrichtung zum Bedienen des Haushaltsgeräts. Die Bedieneinrichtung weist ein piezoelektrisches Element auf, wie auch ein Paar von an dem piezoelektrischen Element angeordneten Kontaktelementen. Die Bedieneinrichtung beinhaltet außerdem eine mit den Kontaktelementen elektrisch gekoppelte elektronische Auswerteschaltung, die zum Erzeugen zumindest eines Steuersignals - zum Beispiel für eine Komponente des Haushaltsgeräts - ausgebildet ist. Die Auswerteschaltung ist dazu ausgebildet, eine Änderung einer elektrischen Kapazität zwischen den Kontaktelementen bezüglich einer Ausgangskapazität zu erfassen und in Abhängigkeit von der Änderung der Kapazität das zumindest eine Steuersignal zu erzeugen.

Also wird erfindungsgemäß durch die Auswerteschaltung nicht wie im Stand der Technik die Amplitude der erzeugten Spannung des piezoelektrischen Elementes, sondern eine Änderung der elektrischen Kapazität zwischen den Kontaktelementen detektiert. Der Erfindung liegen mehrere Erkenntnisse zugrunde: Sie beruht zunächst auf der Erkenntnis, dass im Stand der Technik die Detektion eines über eine längere Zeit andauernden Drucks auf das piezoelektrische Element auch bei einem hochohmigen Eingangswiderstand der Auswerteschaltung nicht detektiert werden kann. Die Erfindung basiert ferner auf der Erkenntnis, dass der Einsatz einer Auswerteschaltung mit einem hochohmigen Eingangswiderstand größer als 50MΩ mit diversen Nachteilen verbunden ist, nämlich hinsichtlich der EMV-Eigenschaften. Die Erfindung baut weiterhin auf der Erkenntnis auf, dass die Änderung der Kapazität bei einem typischen piezoelektrischen Element ähnlich wie bei kapazitiven Annäherungsschaltern, wie sie aus dem Stand der Technik - beispielsweise aus der Druckschrift DE 10 2005 041 113 A1 - bekannt sind, im pF-Bereich liegt. Der Erfindung liegt schließlich die Erkenntnis zugrunde, dass die Auswerteschaltungen, wie sie zum Auswerten der Änderungen der Kapazität eines Annäherungsschalters eingesetzt werden, auch zum Auswerten einer Änderung der Kapazität zwischen zwei Kontaktelementen bei einem piezoelektrischen Element vorteilhaft eingesetzt werden können.

Die Erfindung hat diverse Vorteile: Es kann zur Detektion der Änderung der Kapazität eine Auswerteschaltung mit einem niederohmigen Eingangswiderstand eingesetzt werden; dann wird der Problematik der elektromagnetischen Verträglichkeit begegnet, und die Auswerteschaltung kann in einem größeren Abstand von dem piezoelektrischen Element angeordnet sein. Die Kapazität zwischen den Kontaktelementen ändert sich beim Ausüben eines Drucks auf das piezoelektrische Element, so dass selbiges Element - anders als bei kapazitiven Annäherungsschaltern - auch hinter einer metallischen Abdeckung angeordnet sein kann. Die Änderung der Kapazität kann nämlich auch in einem solchen Fall detektiert werden. Weil die Änderung der Kapazität zwischen den Kontaktelementen unter Druck auf das piezoelektrische Element bestehen bleibt, kann ferner eine Zeitdauer eines Tastendrucks gemessen werden. Auch eine Stärke des Drucks auf das piezoelektrische Element kann abhängig von der Änderung der Kapazität gemessen werden. Insgesamt können somit mit dem piezoelektrischen Element verschiedenste Funktionen des Haushaltsgeräts gesteuert werden. Ein weiterer Vorteil der Erfindung besteht darin, dass die Bedieneinrichtung keiner mechanischen Abnutzung unterliegt; auch Feuchtigkeit und Wasser haben keinen Einfluss auf die Auswertung der Kapazität und beeinträchtigen somit nicht die Bedienung des Haushaltsgeräts.

Unter einem Haushaltsgerät wird vorliegend ein Gerät verstanden, das zur Haushaltsführung eingesetzt wird. Das kann ein Haushaltsgroßgerät sein, wie beispielsweise eine Waschmaschine, ein Wäschetrockner, eine Geschirrspülmaschine, ein Gargerät, eine Dunstabzugshaube, ein Kältegerät, eine Kühl-Gefrier-Kombination oder ein Klimagerät. Das kann aber auch ein Haushaltskleingerät sein, wie beispielsweise ein Kaffeevollautomat oder eine Küchenmaschine.

Die Auswerteschaltung kann die Änderung der elektrischen Kapazität zwischen den Kontaktelementen erfassen und in Abhängigkeit davon zumindest ein Steuersignal erzeugen. Bezüglich der Erfassung der Kapazitätsänderung, wie auch bezüglich des zumindest einen Steuersignals sind unterschiedlichste Ausführungsformen vorgesehen:
Die Auswerteschaltung kann beispielsweise einen binären Zustand des piezoelektrischen Elementes detektieren, nämlich ob selbiges Element gedrückt ist oder nicht. Bei dieser Ausführungsform kann die Auswerteschaltung ein binäres Steuersignal erzeugen, welches zwei logische Zustände aufweist. Das binäre Steuersignal kann einen ersten logischen Zustand - beispielsweise logische Null - dann einnehmen, wenn eine Änderung der Kapazität detektiert wird bzw. vorhanden ist. Einen zweiten logischen Zustand - z. B. eine logische Eins - kann das binäre Steuersignal dann einnehmen, wenn die Änderung der Kapazität unterbleibt bzw. wenn keine Änderung der Kapazität gegenüber der Ausgangskapazität gegeben ist. Diese Ausführungsform hat insbesondere Vorteile bei der Auswahl einer Funktion des Haushaltsgeräts, beispielsweise einer Zusatzfunktion, wie auch beim Überführen des Haushaltsgeräts von einem Ruhezustand in einen Aktivzustand (Standby-Zustand). Eine solche Vorgehensweise kann jedoch auch zum Einleiten und/oder zum Anhalten eines Programms des Haushaltsgeräts genutzt werden: Eine Bedienperson kann das piezoelektrische Element einmal drücken und hierdurch ein Programm des Haushaltsgeräts starten; nach einer weiteren Betätigung des Elements kann dieses eingeleitete Programm angehalten werden.

Ergänzend oder alternativ kann die Auswerteschaltung einen Grad der Änderung der Kapazität erfassen. Dann kann die Auswerteschaltung ein solches Steuersignal erzeugen, welches den erfassten Grad der Änderung der Kapazität charakterisiert. Dann kann die Auswerteschaltung ein solches Steuersignal erzeugen, welches den erfassten Grad der Änderung der Kapazität charakterisiert. Diese Ausführungsform macht sich die Tatsache zunutze, dass die Änderung der Kapazität von der Stärke des auf das piezoelektrische Element ausgeübten Drucks abhängt. Der Grad der Änderung der Kapazität stellt also ein Maß für die Stärke des Drucks dar, was weitere Möglichkeiten hinsichtlich der Bedienung des Haushaltsgeräts mit Hilfe des piezoelektrischen Elementes bietet. Zum Beispiel kann mit Hilfe des piezoelektrischen Elementes ein Wert eines Parameters des Haushaltsgeräts eingestellt werden, in dem ein Druck entsprechender Stärke auf das piezoelektrische Element ausgeübt wird. Die Bedienperson kann beispielsweise das piezoelektrische Element leicht drücken, um einen geringen Wert eines Parameters einzustellen. Man würde hingegen einen Druck hoher Stärke auf das piezoelektrische Element ausüben, um einen relativ großen Wert eines Parameters einzustellen.

Die Auswerteschaltung erfasst eine Zeitdauer, während welcher die Kapazität zwischen den Kontaktelementen gegenüber der Ausgangskapazität verändert bzw. das piezoelektrische Element im gedrückten Zustand verbleibt. Abhängig von dieser Zeitdauer kann die Auswerteschaltung dann ein Steuersignal erzeugen, welches diese erfasste Zeitdauer charakterisiert. Eine solche Vorgehensweise ist bei der Auswertung der Amplitude der induzierten Spannung, wie sie im Stand der Technik erfolgt, nicht möglich. Demgegenüber kann die Zeitdauer des Vorhandenseins der Kapazitätsänderung durch die Auswerteschaltung ohne viel Aufwand erfasst werden. Es wird auf diese Art und Weise eine weitere Bedienart des Haushaltsgeräts geschaffen; die Bedienperson kann das piezoelektrische Element so lange drücken, bis eine gewünschte Funktion ausgewählt oder ein gewünschter Wert eines Parameters eingestellt wird.

Wie bereits ausgeführt, kann bei der Bedieneinrichtung eine Auswerteschaltung mit einem niederohmigen Eingangswiderstand eingesetzt werden. Es erübrigt sich also der Einsatz eines hochohmigen Eingangswiderstands mit den damit verbundenen Nachteilen hinsichtlich der elektromagnetischen Verträglichkeit. Die Auswerteschaltung kann bei dieser Ausführungsform auch in einem großen Abstand von dem piezoelektrischen Element angeordnet sein, was insbesondere die Planung der Verteilung unterschiedlichster Komponenten im Haushaltsgerät erleichtert. Es hat sich als vorteilhaft herausgestellt, wenn der Wert des Eingangswiderstands kleiner als 2 kΩ, insbesondere kleiner als 1 kΩ, ist.

Das piezoelektrische Element mit den daran angeordneten Kontaktelementen kann zwischen einem Trägerteil, beispielsweise einer Basisplatte, und einem Abdeckelement (so genanntes "Overlay") angeordnet sein. Dann können die Form des piezoelektrischen Elementes und hierdurch die elektrische Kapazität zwischen den Kontaktelementen durch Ausüben eines Drucks auf das Abdeckelement verändert werden. Prinzipiell kann das Abdeckelement aus Plastik und/oder aus Glas bereitgestellt sein; es ist jedoch auch - anders als bei kapazitiven Annäherungsschaltern - der Einsatz eines metallischen Abdeckelements möglich. Zum Beispiel kann das Abdeckelement zumindest bereichsweise, insbesondere vollständig bzw. flächendeckend, aus Metall ausgebildet sein. Eine solche Ausführung des Abdeckelements bietet Vorteile hinsichtlich der elektromagnetischen Verträglichkeit; das Abdeckelement stellt dann nämlich eine Abschirmung gegen elektrische Störfelder dar. Als Materialien seien hier beispielsweise Aluminium und/oder Chromstahl genannt. Ist das Abdeckelement aus Metall ausgebildet, so ist es bevorzugt in Form einer dünnen Metallfolie bereitgestellt, mit welcher das piezoelektrische Element überdeckt ist. Die Metallfolie kann beispielsweise eine Dicke von etwa 0,1 mm aufweisen. Einerseits wird hierdurch eine optisch ansprechende Ausgestaltung der Bedieneinrichtung erzielt, andererseits ist die Bedienung des Haushaltsgeräts somit besonders komfortabel.

Es kann als Auswerteschaltung eine solche eingesetzt werden, wie sie in der Druckschrift DE 10 2005 041 113 A1 beschrieben ist. Die Erfindung ist jedoch nicht auf diese Art der Auswerteschaltung beschränkt.

Die Bedieneinrichtung kann zumindest zwei piezoelektrische Elemente umfassen. Dann kann die Bedieneinrichtung zu jedem piezoelektrischen Element jeweils ein Paar von Kontaktelementen aufweisen, die mit der Auswerteschaltung elektrisch gekoppelt sind. Die Auswerteschaltung kann zu jedem Paar von Kontaktelementen jeweils eine Änderung einer elektrischen Kapazität erfassen, nämlich wie oben bereits beschrieben. In Abhängigkeit von der Änderung der jeweiligen Kapazität kann die Auswerteschaltung jeweils zumindest ein Steuersignal erzeugen. Der Bedienperson stehen somit eine Vielzahl von piezoelektrischen Elementen für die Bedienung des Haushaltsgeräts zur Verfügung. Die Auswerteschaltung kann die jeweilige Kapazitätsänderung beispielsweise nach einem Multiplexverfahren auswerten, wie es im Gegenstand gemäß Druckschrift DE 10 2005 041 113 A1 eingesetzt wird.

Bei einem erfindungsgemäßen Verfahren wird ein Haushaltsgerät mit Hilfe eines piezoelektrischen Elements bedient, an welchem ein Paar von Kontaktelementen angeordnet ist. Es wird eine Änderung einer elektrischen Kapazität zwischen den Kontaktelementen bezüglich einer Ausgangskapazität durch eine elektronische Auswerteschaltung erfasst. In Abhängigkeit von der Änderung der Kapazität wird zumindest ein Steuersignal durch die Auswerteschaltung erzeugt.

Die mit Bezug auf das erfindungsgemäße Haushaltsgerät vorgestellten bevorzugten Ausführungsformen und deren Vorteile gelten entsprechend für das erfindungsgemäße Verfahren.

Weitere Merkmale der Erfindung ergeben sich aus den Ansprüchen, den Figuren und der Figurenbeschreibung. Alle vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar.

Die Erfindung wird nun anhand einzelner bevorzugter Ausführungsbeispiele näher erläutert, wie auch unter Bezugnahme auf die beigefügten Zeichnungen.

Es zeigen:
- Fig. 1: in schematischer Darstellung einen Querschnitt durch ein zwischen einem Abdeckelement und einem Trägerteil angeordnetes piezoelektrisches Element mit einer schematisch dargestellten Auswerteschaltung;
- Fig. 2: eine Auswerteschaltung eines Haushaltsgeräts gemäß einer Ausführungsform der Erfindung.

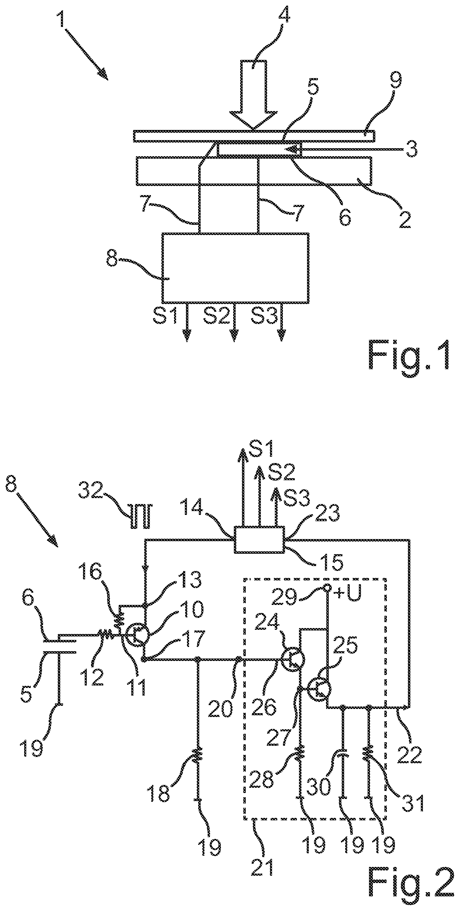

Eine Bedieneinrichtung 1, wie sie in Fig. 1 dargestellt ist, dient zum Bedienen eines Haushaltsgeräts. Die Bedieneinrichtung 1 umfasst ein Trägerteil 2 in Form einer Basisplatte. Auf dem Trägerteil 2 ist ein piezoelektrisches Element 3 angeordnet. Das piezoelektrische Element 3 liegt an dem Trägerteil 2 an. Eine Betätigungsrichtung des piezoelektrischen Elements 3 ist in Fig. 1 mit einem Pfeil 4 symbolisiert.

Das piezoelektrische Element 3 besteht aus einem piezoelektrischen Material. An dem piezoelektrischen Element 3 ist auf beiden Seiten quer zur Betätigungsrichtung 4 jeweils ein in Form einer metallischen Platte ausgeführtes Kontaktelement 5, 6 angeordnet. Die elektrisch leitenden Kontaktelemente 5, 6 sind jeweils über eine Leitung 7 mit einer Auswerteschaltung 8 elektrisch verbunden.

Über dem piezoelektrischen Element 3 ist eine Abdeckplatte bzw. ein Abdeckelement 9 derart angeordnet, dass sich das piezoelektrische Element 3 quasi in einer SandwichBauweise zwischen dem Trägerteil 2 und dem Abdeckelement 9 befindet. Im Ausführungsbeispiel kann das Abdeckelement 9 eine Metallfolie einer Dicke von etwa 0,1 mm sein. Zwischen dem Abdeckelement 9 und dem piezoelektrischen Element 3 kann auch eine elektrisch isolierende Schicht angeordnet sein. Das Abdeckelement 9 stellt im Ausführungsbeispiel eine äußerste Wandung einer Bedienblende des Haushaltsgeräts dar und kann somit durch eine Bedienperson des Haushaltsgeräts ertastet werden.

Durch Drücken des Abdeckelements 9 und hierdurch des piezoelektrischen Elements 3 in Betätigungsrichtung 4 ändert sich die Form des piezoelektrischen Elements 3. Das Element 3 wird zusammengedrückt, und es wird eine elektrische Spannung zwischen den Kontaktelementen 5, 6 erzeugt. Es ist jedoch nicht die elektrische Spannung, die durch die Auswerteschaltung 8 ausgewertet wird. Die Auswerteschaltung 8 erfasst eine Änderung einer elektrischen Kapazität zwischen den Kontaktelementen 5, 6, nämlich bezüglich einer Ausgangskapazität. Diese Ausgangskapazität ist diejenige Kapazität zwischen den Kontaktelementen 5, 6, die bei einem nicht-gedrückten piezoelektrischen Element 3 herrscht. Somit können äußere Einflüsse, beispielsweise die Einflüsse der Umgebungstemperatur und Ähnliches eliminiert werden.

Die Auswerteschaltung kann im Ausführungsbeispiel drei verschiedene Steuersignale S1, S2, S3 erzeugen und ausgeben. Es ist auch möglich, dass die Auswerteschaltung 8 lediglich eins oder zwei der Steuersignale S1, S2, S3 erzeugt und ausgibt. Die Steuersignale S1, S2, S3, können beispielsweise an eine Steuereinrichtung oder eine weitere Komponente des Haushaltsgeräts ausgegeben werden. Die Steuersignale S1, S2, S3 beinhalten dabei Informationen über den aktuellen Betätigungszustand des piezoelektrischen Elements 3. Im Einzelnen werden die Steuersignale S1, S2, S3 nachfolgend näher beschrieben.
Das Steuersignal S1 ist ein binäres digitales Steuersignal. Das Steuersignal S1 kann zwei verschiedene logische Zustände einnehmen, nämlich beispielsweise eine logische Null und eine logische Eins. Und zwar nimmt das Steuersignal S1 einen der Zustände abhängig davon ein, ob das piezoelektrische Element 3 momentan gedrückt ist oder nicht. Ist das piezoelektrische Element 3 nicht gedrückt, so weist das Steuersignal S1 den ersten logischen Zustand auf, nämlich die logische Null. Ist hingegen das Element 3 gedrückt, so weist das Steuersignal S1 den zweiten Zustand auf, nämlich die logische Eins. Also kann die Auswerteschaltung 8 die Betätigung des Elements 3 feststellen und nach Feststellen einer Betätigung den Zustand des Steuersignals S1 ändern.
Das zweite Steuersignal S2 charakterisiert einen Grad der Änderung der Kapazität zwischen den Kontaktelementen 5, 6. Mit anderen Worten gibt das Steuersignal S2 die Stärke des auf das Element 3 ausgeübten Drucks wieder. Also kann die Auswerteschaltung 8 den Grad der Änderung der Kapazität erfassen und das Steuersignal S2 abhängig von diesem Grad erzeugen. Der Grad der Änderung der Kapazität kann beispielsweise durch eine Amplitude des Steuersignals S2 wiedergegeben sein; in diesem Fall ist das Steuersignal S2 ein analoges Signal.

Durch das erfindungsgemäße dritte Steuersignal S3 ist eine Zeitdauer charakterisiert, während welcher die Änderung der Kapazität andauert. Dies bedeutet, dass die Auswerteschaltung 8 die Zeitdauer erfassen kann, über welche das piezoelektrische Element 3 gedrückt bleibt und somit die Kapazität zwischen den Kontaktelementen 5, 6 gegenüber der Ausgangskapazität verändert bleibt. Eine Bedienperson kann somit das Element 3 so lange drücken, wie es beispielsweise für die Einstellung eines Wertes eines Betriebsparameters des Haushaltsgeräts erforderlich ist. Diese Zeitdauer, während welcher die Kapazität ungleich der Ausgangskapazität ist, wird durch die Auswerteschaltung 8 erfasst, und das Steuersignal S3 wird entsprechend erzeugt. Das Steuersignal S3 wird während des Drückens des Elements 3 erzeugt und kontinuierlich während des Drückens des Elements 3 verändert. Dies sieht so aus, dass die Zeitdauer des Drückens des Elements 3 durch eine Amplitude des Steuersignals S3 charakterisiert ist; dann erhöht sich die Amplitude des Steuersignals S3 kontinuierlich während der Betätigung des Elements 3.
Die Auswerteschaltung 8 weist einen niederohmigen Eingangswiderstand auf, welcher kleiner als 1 kΩ ist.
Die Auswerteschaltung 8 kann beispielsweise eine solche sein, wie sie im Gegenstand gemäß Druckschrift DE 10 2005 041 113 A1 eingesetzt wird. Die Erfindung ist jedoch nicht auf den Einsatz einer solchen Auswerteschaltung 8 beschränkt. Eine solche mögliche Auswerteschaltung 8 ist in Fig. 2 näher dargestellt.
Die Auswerteschaltung 8 weist einen PNP-Bipolartransistor 10 auf, mit dessen Steuereingang 11, also mit dessen Basis, das Kontaktelement 6 über einen Widerstand 12 gekoppelt ist. Der Bipolartransistor 10 ist mit seinem Emitter 13 mit einem Ausgang 14 eines Mikroprozessors 15 verbunden. Zwischen dem Emitter 13 und dem Steuereingang 11 ist ein Widerstand 16 geschaltet. Der Kollektor 17 des Bipolartransistors 10 ist sowohl über einen Widerstand 18 mit einem Bezugspotential 19 gekoppelt als auch mit einem Eingang 20 eines Abtast-Halte-Gliedes (sample and hold) 21 direkt verbunden. Ein Ausgang 22 des Abstast-Halte-Gliedes 21 ist direkt mit einem Eingang 23 des Mikroprozessors 15 verbunden. Das Abtast-Halte-Glied 21 umfasst zwei NPN-Bipolartransistoren 24, 25. Ein Steuereingang 26 des Bipolartransistors 24 ist mit dem Eingang 20 verbunden, während der Emitter des Bipolartransistors 24 über einen Steuereingang 27 und einen Widerstand 28 mit dem Bezugspotential 19 gekoppelt ist. Der Kollektor des Bipolartransistors 24 ist mit einer Gleichspannungsquelle 29 verbunden, welche eine Gleichspannung +U bereitstellt. Mit dieser Gleichspannungsquelle 29 ist ebenfalls der Kollektor des Bipolartransistors 25 verbunden. Sein Emitter ist einerseits direkt mit dem Ausgang 22 verbunden und andererseits über eine Parallelschaltung aus einem Kondensator 30 und einem Widerstand 31 mit dem Bezugspotential 19 gekoppelt. Das Kontaktelement 5 liegt auf dem Bezugspotential 19 an.

Der Mikroprozessor 15 stellt an seinem Ausgang 14 ein Taktsignal 32 mit einem niedrigen Pegel und einem hohen Pegel bereit. Während der Zeitdauer des niedrigen Pegels des Taktsignals 32 ist der Bipolartransistor 10 gesperrt. Mit dem hohen Pegel des Taktsignals 32 wird ein durch die Kontaktelemente 5, 6 gebildeter Kondensator aufgeladen, wobei während des Aufladens der Bipolartransistor 10 leitend ist. Am Eingang 20 des Abtast-Halte-Gliedes 21 liegt somit ein entsprechendes Taktsignal an, dessen Signalanteile proportional zu der Kapazität zwischen den Kontaktelementen 5, 6 sind. Dieses Taktsignal wird mit Hilfe des Abtast-Halte-Gliedes 21 in ein Gleichspannungssignal umgewandelt und liegt an dem Eingang 23 des Mikroprozessors 15 an. Der Mikroprozessor 15 kann dann dieses Gleichspannungssignal auswerten; dieses Gleichspannungssignal ist ein Maß für die Kapazitätsänderung zwischen den Kontaktelementen 5, 6. Abhängig von dem Gleichspannungssignal kann der Mikroprozessor 15 die Steuersignale S1, S2, S3 erzeugen und ausgeben.

Es ist auch üblich, mehrere piezoelektrische Elemente 3 bei der Bedieneinrichtung 1 einzusetzen. Dann kann die Auswertung der jeweiligen Änderungen der Kapazitäten nacheinander erfolgen, nämlich gemäß einem Multiplexverfahren, wie es in der Druckschrift DE 10 2005 041 113 A1 beschrieben ist. Jedem piezoelektrischen Element 3 ist dann jeweils ein Bipolartransistor 10 zugeordnet, während ein Abtast-Halte-Glied 21 jeweils einer vorgegebenen Gruppe von Elementen 3 - zum Beispiel von drei Elementen 3 - zugeordnet ist.

Insgesamt wird also eine Bedieneinrichtung 1 geschaffen, bei welcher eine Auswerteschaltung 8 mit einem niederohmigen Eingangswiderstand eingesetzt werden kann. Es wird eine Änderung einer Kapazität zwischen zwei Kontaktelementen erfasst und ausgewertet, welche an einem piezoelektrischen Element 3 angeordnet sind. Die Änderung der Kapazität wird anstatt einer Amplitude einer durch das piezoelektrische Element 3 erzeugten Spannung erfasst. Diese Vorgehensweise hat den Vorteil, dass auch über längere Zeit andauernder Druck auf das piezoelektrische Element 3 erfasst werden kann.

### Bezugszeichenliste

- 1: Bedieneinrichtung
- 2: Trägerteil
- 3: piezoelektrisches Element
- 4: Betätigungsrichtung
- 5, 6: Kontaktelemente
- 7: Leitung
- 8: Auswerteschaltung
- 9: Abdeckelement
- 10, 24, 25: Bipolartransistoren
- 11, 26, 27: Steuereingänge
- 12: Widerstand
- 13: Emitter
- 14, 22: Ausgänge
- 15: Mikroprozessor
- 16, 18, 28, 31: Widerstände
- 17: Kollektor
- 19: Bezugspotential
- 20, 23: Eingänge
- 21: Abtast-Halte-Glied
- 29: Gleichspannungsquelle
- 30: Kondensator
- 32: Taktsignal

- S1, S2, S3: Steuersignale

## Patentansprüche

1. Haushaltsgerät mit einer Bedieneinrichtung (1) zum Bedienen des Haushaltsgeräts, welche umfasst: ein piezoelektrisches Element (3), ein Paar von an dem piezoelektrischen Element (3) angeordneten Kontaktelementen (5, 6) und eine mit den Kontaktelementen (5, 6) elektrisch gekoppelte elektronische Auswerteschaltung (8) zum Erzeugen zumindest eines Steuersignals (S1, S2, S3), wobei die Auswerteschaltung (8) dazu ausgebildet ist, eine Änderung einer elektrischen Kapazität zwischen den Kontaktelementen (5, 6) bezüglich einer Ausgangskapazität zu erfassen und in Abhängigkeit von der Änderung der Kapazität das zumindest eine Steuersignal (S1, S2, S3) zu erzeugen, **dadurch gekennzeichnet, dass** die Auswerteschaltung (8) weiterhin dazu ausgelegt ist, eine Zeitdauer zu erfassen, für welche die Kapazität zwischen den Kontaktelementen (5, 6) gegenüber der Ausgangskapazität verändert bleibt, und ein diese Zeitdauer charakterisierendes Steuersignal (S3) zu erzeugen, wobei die Zeitdauer des Drückens des Elements (3) durch eine Amplitude des Steuersignals (S3) charakterisiert ist; dergestalt dass sich die Amplitude des Steuersignals (S3) kontinuierlich während der Betätigung des Elements (3) erhöht.

2. Haushaltsgerät nach Anspruch 1, **dadurch gekennzeichnet, dass** die Auswerteschaltung (8) dazu ausgelegt ist, ein binäres Steuersignal (S1) zu erzeugen, welches einen das Vorhandensein der Änderung der Kapazität charakterisierenden ersten logischen Zustand und einen das Nichtvorhandensein der Änderung der Kapazität charakterisierenden zweiten logischen Zustand aufweist.

3. Haushaltsgerät nach Anspruch 1 oder 2, **dadurch gekennzeichnet, dass** die Auswerteschaltung (8) dazu ausgelegt ist, einen Grad der Änderung der Kapazität zu erfassen und ein diesen Grad charakterisierendes Steuersignal (S2) zu erzeugen.

4. Haushaltsgerät nach einem der vorhergehenden Ansprüche, **dadurch gekennzeichnet, dass** die Auswerteschaltung (8) einen niederohmigen elektrischen Eingangswiderstand, insbesondere kleiner als 2 Kiloohm, bevorzugt kleiner als 1 Kiloohm, aufweist.

5. Haushaltsgerät nach einem der vorhergehenden Ansprüche, **dadurch gekennzeichnet, dass** das piezoelektrische Element (3) zwischen einem Trägerteil (2) und einem Abdeckelement (9) angeordnet ist und durch Ausüben eines Drucks auf das Abdeckelement (9) eine Form des piezoelektrischen Elementes (3) und hierdurch die elektrische Kapazität zwischen den Kontaktelementen (5, 6) veränderbar sind.

6. Haushaltsgerät nach Anspruch 5, **dadurch gekennzeichnet, dass** das Abdeckelement (9) zumindest bereichsweise aus Metall ausgebildet ist.

7. Haushaltsgerät nach einem der vorhergehenden Ansprüche, **dadurch gekennzeichnet, dass** die Bedieneinrichtung (1) zumindest zwei piezoelektrische Elemente (3) und zu jedem piezoelektrischen Element (3) jeweils ein Paar von mit der Auswerteschaltung (8) elektrisch gekoppelten Kontaktelementen (5, 6) aufweist und die Auswerteschaltung (8) dazu ausgebildet ist, zu jedem Paar von Kontaktelementen (5, 6) jeweils eine Änderung einer elektrischen Kapazität zu erfassen und in Abhängigkeit von der Änderung der Kapazität jeweils zumindest ein Steuersignal (S1, S2, S3) zu erzeugen.

8. Verfahren zum Bedienen eines Haushaltsgeräts mithilfe eines piezoelektrischen Elements (3), an welchem ein Paar von Kontaktelementen (5, 6) angeordnet ist, mit den Schritten:
- Erfassen einer Änderung einer elektrischen Kapazität zwischen den Kontaktelementen (5, 6) bezüglich einer Ausgangskapazität durch eine elektronische Auswerteschaltung (8) und
- Erzeugen zumindest eines Steuersignals (S1, S2, S3) durch die Auswerteschaltung (8) in Abhängigkeit von der Änderung der Kapazität,
**dadurch gekennzeichnet, dass** die Auswerteschaltung (8) eine Zeitdauer erfasst, für welche die Kapazität zwischen den Kontaktelementen (5, 6) gegenüber der Ausgangskapazität verändert bleibt, und ein diese Zeitdauer charakterisierendes Steuersignal (S3) erzeugt, wobei die Zeitdauer des Drückens des Elements (3) durch eine Amplitude des Steuersignals (S3) charakterisiert ist; dergestalt dass sich die Amplitude des Steuersignals (S3) kontinuierlich während der Betätigung des Elements (3) erhöht.

## Claims

1. Household appliance having a control apparatus (1) for operating the household appliance which comprises a piezoelectric element (3), a pair of contact elements (5, 6) arranged on the piezoelectric element (3) and an electronic evaluation circuit (8) which is electrically coupled to the contact elements (5, 6) for generating at least one control signal (S1, S2, S3), wherein the evaluation circuit (8) is designed to detect a change in an electrical capacitance between the contact elements (5, 6) in relation to an output capacitance and to generate the at least one control signal (S1, S2, S3) as a function of the change in capacitance, **characterised in that** the evaluation circuit (8) is further designed to detect a duration for which the capacitance between the contact elements (5, 6) remains changed compared to the output capacitance, and to generate a control signal (S3) characterising this duration, wherein the duration of pressing the element (3) is **characterised by** an amplitude of the control signal (S3), such that the amplitude of the control signal (S3) increases continuously during the actuation of the element (3).

2. Household appliance according to claim 1, **characterised in that** the evaluation circuit (8) is designed to generate a binary control signal (S1), which has a first logic state characterising the presence of the change in capacitance and a second logic state characterising the absence of the change in capacitance.

3. Household appliance according to claim 1 or 2, **characterised in that** the evaluation circuit (8) is designed to detect a degree of change in capacitance and to generate a control signal (S2) characterising said degree.

4. Household appliance according to one of the preceding claims, **characterised in that** the evaluation circuit (8) has a low-impedance electrical input resistance, in particular less than 2 kilohms, preferably less than 1 kilohm.

5. Household appliance according to one of the preceding claims, **characterised in that** the piezoelectric element (3) is arranged between a carrier part (2) and a cover element (9) and by exerting pressure on the cover element (9) a shape of the piezoelectric element (3) and consequently the electrical capacitance between the contact elements (5, 6) are variable.

6. Household appliance according to claim 5, **characterised in that** the cover element (9) is at least partially formed of metal.

7. Household appliance according to one of the preceding claims, **characterised in that** the control apparatus (1) has at least two piezoelectric elements (3) and for each piezoelectric element (3) in each case a pair of contact elements (5, 6) electrically coupled to the evaluation circuit (8) and the evaluation circuit (8) is designed to detect, for each pair of contact elements (5, 6), in each case a change in an electrical capacitance and to generate at least one control signal (S1, S2, S3) as a function of the change in capacitance in each case.

8. Method for operating a household appliance using a piezoelectric element (3) on which a pair of contact elements (5, 6) is arranged, comprising the steps:
- detection of a change in an electrical capacitance between the contact elements (5, 6) in relation to an output capacitance by an electronic evaluation circuit (8) and
- generation of at least one control signal (S1, S2, S3) by the evaluation circuit (8) as a function of the change in capacitance,
**characterised in that** the evaluation circuit (8) detects a duration for which the capacitance between the contact elements (5, 6) remains changed compared to the output capacitance, and generates a control signal (S3) characterising said duration, wherein the duration of pressing the element (3) is **characterised by** an amplitude of the control signal (S3), such that the amplitude of the control signal (S3) increases continuously during the actuation of the element (3).

## Revendications

1. Appareil ménager comportant un dispositif de commande (1) pour commander l'appareil ménager qui comprend : un élément piézoélectrique (3), une paire d'éléments de contact (5, 6) disposés sur l'élément piézoélectrique (3) et un circuit d'évaluation (8) électronique couplé électriquement aux éléments de contact (5, 6) et destiné à produire au moins un signal de commande (S1, S2, S3), dans lequel le circuit d'évaluation (8) est conçu de manière à détecter une modification d'une capacité électrique entre les éléments de contact (5, 6) par rapport à une capacité initiale et à produire le au moins un signal de commande (S1, S2, S3) en fonction de la modification de la capacité,
**caractérisé en ce que** le circuit d'évaluation (8) est conçu en outre de manière à détecter une durée pendant laquelle la capacité entre les éléments de contact (5, 6) reste modifiée par rapport à la capacité initiale et à produire un signal de commande (S3) caractéristique de cette durée, la durée d'appui de l'élément (3) étant **caractérisée par** une amplitude du signal de commande (S3), de telle sorte que l'amplitude du signal de commande (S3) augmente en continu pendant l'actionnement de l'élément (3).

2. Appareil ménager selon la revendication 1, **caractérisé en ce que** le circuit d'évaluation (8) est conçu de manière à produire un signal de commande binaire (S1) qui comprend un premier état logique caractérisant la présence d'une modification de la capacité et un second état logique caractérisant l'absence de modification de la capacité.

3. Appareil ménager selon la revendication 1 ou 2, **caractérisé en ce que** le circuit d'évaluation (8) est conçu de manière à détecter un degré de modification de la capacité et à produire un signal de commande (S2) caractérisant ce degré.

4. Appareil ménager selon l'une quelconque des revendications précédentes, **caractérisé en ce que** le circuit d'évaluation (8) comprend une résistance d'entrée électrique de faible impédance, notamment inférieure à 2 kilo-ohms, et de préférence inférieure à 1 kilo-ohm.

5. Appareil ménager selon l'une quelconque des revendications précédentes, **caractérisé en ce que** l'élément piézoélectrique (3) est disposé entre un élément de support (2) et un élément de recouvrement (9) et **en ce que** la forme de l'élément piézoélectrique (3) et par cela la capacité électrique entre les éléments de contact (5, 6) peuvent être modifiées en exerçant une pression sur l'élément de recouvrement (9).

6. Appareil ménager selon la revendication 5, **caractérisé en ce que** l'élément de recouvrement (9) est formé au moins en partie de métal.

7. Appareil ménager selon l'une des revendications précédentes, **caractérisé en ce que** le dispositif de commande (1) comporte au moins deux éléments piézoélectriques (3) et, respectivement, sur chaque élément piézoélectrique (3), une paire d'éléments de contact (5, 6) couplés électriquement au circuit d'évaluation (8) et le circuit d'évaluation (8) est conçu de manière à détecter, pour chaque paire d'éléments de contact (5, 6), respectivement une modification d'une capacité électrique et à produire au moins un signal de commande (S1, S2, S3) en fonction d'une modification d'une capacité électrique.

8. Procédé de commande d'un appareil ménager à l'aide d'un élément piézoélectrique (3), sur lequel une paire d'éléments de contact (5, 6) sont disposés,
le procédé comprenant les étapes suivantes :
- détection par un circuit d'évaluation (8) électronique d'une modification d'une capacité électrique entre les éléments de contact (5,6) par rapport à une capacité initiale,
- production d'au moins un signal de commande (S1, S2, S3) par le circuit d'évaluation (8) en fonction de la modification de la capacité,
**caractérisé en ce que**
le circuit d'évaluation (8) détecte une durée pendant laquelle la capacité entre les éléments de contact (5, 6) reste modifiée par rapport à la capacité initiale et produit un signal de commande (S3) caractérisant cette durée, la durée d'appui sur l'élément (3) étant **caractérisée par** une amplitude du signal de commande (S3), de manière à ce que l'amplitude du signal de commande (S3) augmente en continu pendant l'actionnement de l'élément (3).
